Europäisches Patentamt

**European Patent Office**

Office européen des brevets

(11) Numéro de publication : **0 006 808**
**B1**

(12) **FASCICULE DE BREVET EUROPÉEN**

(45) Date de publication du fascicule du brevet :
09.09.81

(51) Int. Cl.³ : **H 03 K 7/06**, G 01 P 15/08, H 03 K 13/20

(21) Numéro de dépôt : **79400415.0**

(22) Date de dépôt : **21.06.79**

(54) **Perfectionnement à un intégrateur de précision et capteurs asservis à sorties incrémentales en résultant.**

(30) Priorité : 26.06.78 FR 7818959
20.07.78 FR 7821466

(43) Date de publication de la demande :
09.01.80 (Bulletin 80/01)

(45) Mention de la délivrance du brevet :
09.09.81 Bulletin 81/36

(84) Etats contractants désignés :
BE CH DE GB IT

(56) Documents cités :
US - A - 3 355 952
US - A - 3 429 189
US - A - 3 782 205
US - A - 3 842 371

Electronics, Vol. 45, N° 19, 11 septembre 1972,
NEW YORK (US)
STRONG : « LSI Converts an old technique into
low-cost a-d conversion »
Pages 102-105

Hewlett-Packard Journal, Vol. 24, N° 10, Juin
1973, PALTO ALTO, CALIFORNIE
HORNER et al. : « DMM and DAC Modules
Expand Low-Cost Measuring System »
Pages 7-14

(73) Titulaire : **SOCIETE FRANCAISE D'EQUIPEMENTS POUR LA NAVIGATION AERIENNE (S.F.E.N.A.)**
B.P. 59 Aérodrome de Villacoublay
F-78140 Velizy Villacoublay (FR)

(72) Inventeur : **Willoteaux, Guy**
38, avenue Carnot
F-78100 Saint Germain en Laye (FR)

(74) Mandataire : **Kavos, Stéphane**
B.P. 59 Aérodrome de Villacoublay
F-78140 Velizy Villacoublay (FR)

Imprimerie Jouve, 17, rue du Louvre, 75001 Paris, France

## Perfectionnement à un intégrateur de précision et capteurs asservis à sorties incrémentales en résultant

La présente invention a pour objet un perfectionnement à un intégrateur de précision et les capteurs asservis à sorties incrémentales en résultant.

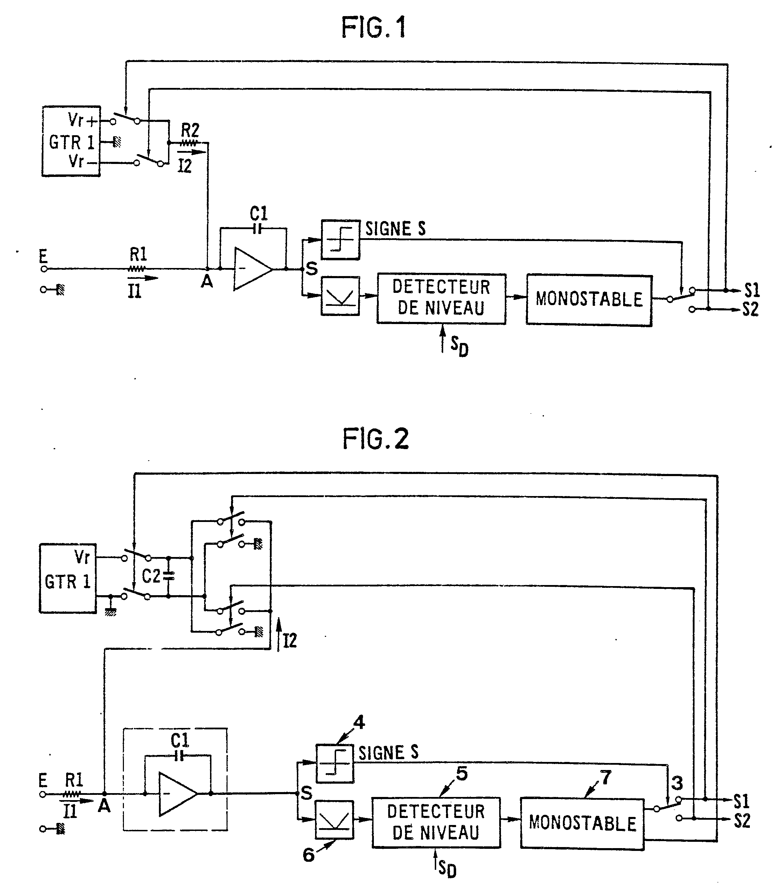

La présente invention s'applique particulièrement aux intégrateurs comprenant un amplificateur opérationnel monté en intégrateur sommateur qui effectue une somme de courants $I_1$ et $I_2$ à l'entrée de l'intégrateur et dans lesquels le courant $I_1$ étant la grandeur à mesurer le courant $I_2$ peut résulter de la connection d'une résistance $R_2$ à un générateur de tensions symétriques de référence (Vr−) ; (Vr+) par l'intermédiaire de deux interrupteurs (fig. 1) ; la sortie de l'intégrateur analogique (point S) étant connectée d'une part, à un inverseur par l'intermédiaire d'une bascule donnant le signe de la tension de sortie, et d'autre part, à un détecteur de niveau par l'intermédiaire d'un redresseur à double alternance, ledit détecteur commandant un circuit monostable relié à chacun des deux interrupteurs par l'intermédiaire de l'inverseur, ayant pour effet de délivrer à travers la résistance $R_2$ des quantités d'électricité calibrées suivant la formule :

$$\Delta Q = I_2 \, \Delta t \text{ avec } I_2 = \text{constante} \quad (1)$$

ou

$$\Delta Q = \frac{Vr \pm}{R_2} \times \Delta t \quad (2)$$

Le principe d'obtenir un courant d'entrée dans un intégrateur par la décharge d'une capacité chargée au moyen d'un générateur de tension simple est connu, voir brevets américains 3 842 371 et 3 355 952 ou encore l'article de Norman Strong paru dans Electronics, vol. 45 N° 19 du 11 Septembre 1972 et intitulé « LSI CONVERTS AN OLD TECHNIQUE INTO ».

La principale difficulté de réalisation des intégrateurs à sorties incrémentales connus réside en ce que, la quantité d'électricité est généralement définie par une impulsion de courant calibré en intensité et en durée.

Un autre inconvénient du montage connu est de nécessiter deux tensions de références symétriques et ajustées.

Un autre inconvénient des montages connus de ce type réside dans leur sensibilité d'une part, à la vitesse de commutation et d'autre part, à la résistance de conduction parasite des interrupteurs.

L'intégrateur de précision à sorties incrémentales selon la présente invention supprime l'ensemble de ces inconvénients.

L'intégrateur de précision selon l'invention est caractérisé en ce que le générateur de tensions symétriques de référence (Vr−) ; (Vr+) est remplacé par un générateur de tension simple (Vr), au moyen duquel une capacité $C_2$ (fig. 2) est chargée, et, en ce que le courant $I_2$ est obtenu par la décharge de ladite capacité $C_2$, ce qui a pour effet de délivrer des quantités d'électricité calibrées suivant la formule :

$$\Delta Q = C_2 \, Vr \quad (3)$$

Dans cet intégrateur les quantités d'électricité sont stockées dans la capacité $C_2$ au moyen d'un interrupteur double de charge, et les quantités d'électricité sont délivrées au moyen de l'un des deux interrupteurs doubles de décharge, de sorte que le courant $I_2$ équilibre le courant $I_1$ quel que soit le sens de celui-ci.

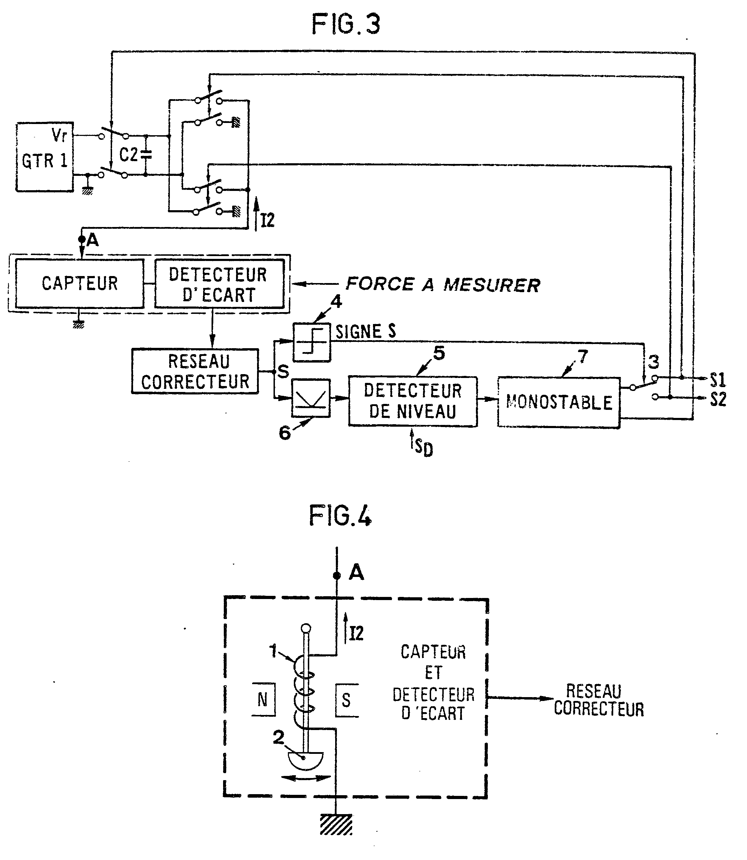

La présente invention a aussi pour objet, un capteur asservi à sorties incrémentales résultant de l'utilisation dudit intégrateur de précision à sorties incrémentales, capteur dans lequel la grandeur à mesurer, primitivement électrique, devient une grandeur physique, mise en évidence par un générateur de force électro-mécanique, par le fait que l'amplificateur analogique de l'intégrateur de précision à sorties incrémentales, (bornes A-S, fig. 2) est remplacé par le générateur de force (fig. 3), dont le courant de rappel est le courant $I_2$ de décharge de la capacité $C_2$, ce qui a pour effet de numériser la boucle d'asservissement.

Ledit capteur étant caractérisé en ce que ledit générateur de force comprend une bobine travaillant en rappel, traversée directement par le courant $I_2$ précité de décharge, ce qui a pour effet de minimiser l'écart entre la grandeur à mesurer convertie en force et la force de rappel de l'électro-aimant.

Un autre objet de capteur, est de s'appliquer indifféremment à tous les capteurs asservis dans tous les cas où la grandeur à mesurer peut être convertie en force, impliquant un générateur de force tel que par exemple un électro-aimant, devant mesurer, à titre d'exemple non limitatif, une accélération ou une vitesse angulaire.

Les caractéristiques et avantages de l'invention apparaîtront au cours de la description qui va suivre des dessins annexés, donnés à titre d'exemple non limitatif.

Les figures 1 et 2 des dessins joints représentent respectivement un circuit d'intégrateur connu (fig. 1) et l'intégrateur de précision selon la présente invention (fig. 2).

La figure 3 est le schéma du capteur asservi à sorties incrémentales résultant de l'utilisation de l'intégrateur de précision selon la présente invention (fig. 2).

La figure 4 est une représentation agrandie du rectangle pointillé de la figure 3.

On voit sur la figure 1, un intégrateur de précision à sorties incrémentales du type comprenant : un amplificateur opérationnel monté en intégrateur, sommateur analogique qui effectue une somme de courants $I_1$ et $I_2$ à l'entrée de l'intégrateur (point A) ; le courant $I_2$ pouvant résulter de la connexion d'une résistance $R_2$ à un générateur de tension symétriques de référence (Vr−) ; (Vr+) par l'intermédiaire de deux interrupteurs (fig. 1) ; la sortie de l'intégrateur analogique (point S) étant connectée d'une part, à un inverseur par l'intermédiaire d'une bascule donnant le signe de la tension de sortie, et d'autre part, à un détecteur de niveau par l'intermédiaire d'un redresseur à double alternance, ledit détecteur commandant un circuit monostable relié à chacun des deux interrupteurs par l'intermédiaire de l'inverseur, ayant pour effet de délivrer à travers la résistance $R_2$ (fig. 1 précitée) des quantités d'électricité calibrées suivant les formules (1) et (2) précitées.

Dans l'intégrateur de précision selon la présente invention (fig. 2) le courant $I_2$ est obtenu par la décharge d'une capacité $C_2$, et le générateur de tensions symétriques de référence (Vr−) ; (Vr+) est remplacé par un générateur de tension simple Vr, et les quantités d'électricité délivrées sont calibrées suivant la formule :

$$\Delta Q = C_2 \, Vr \quad (3)$$

Par ailleurs, des interrupteurs doubles de charge et de décharge sont prévus, reliés en parallèle à la capacité $C_2$. L'interrupteur de charge précité est commandé directement par un circuit monostable (7) et l'inverseur précité commande lesdits interrupteurs de décharge.

Comme précédemment, la sortie de l'intégrateur analogique (point S) est connectée à l'inverseur par l'intermédiaire d'une bascule (4) donnant le signe de la tension de sortie, et d'autre part, à un détecteur de niveau par l'intermédiaire d'un redresseur à double alternance, ledit détecteur commandant le circuit monostable précité.

Nous allons maintenant décrire le mode de fonctionnement de l'intégrateur de précision proposé. Dans le cas général, un intégrateur à sorties incrémentales comprend un intégrateur analogique dont la tension de sortie (S) est asservie, par une boucle supplémentaire de contre réaction, de façon à rester entre deux valeurs limites arbitraires $-S_D$ et $+S_D = -S_D \leqslant S \leqslant S_D$.

$S_D$ est le seuil du détecteur de niveau.

Tant que la tension de sortie de l'intégrateur analogique (S) est comprise entre les limites $-S_D$ et $+S_D$ les deux interrupteurs sont ouverts (fig. 1) et le courant $I_2$ est nul.

Lorsque la tension (S) atteint l'une des limites $-S_D$ et $+S_D$ sous l'effet du courant $I_1$, le détecteur de niveau commande le monostable qui ferme immédiatement un interrupteur pendant une durée définie très précise.

L'interrupteur commandé est déterminé en fonction du signe de la tension S, de façon à ramener celle-ci vers zéro. L'impulsion issue du monostable est reliée à l'une des sorties correspondantes S1 ou S2.

Dans l'intégrateur de précision selon l'invention (fig. 2), quand la tension de sortie de l'intégrateur analogique (S) est comprise entre les limites $-S_D$ et $+S_D$ précitées, l'interrupteur double de charge est fermé et les interrupteurs doubles de décharge ouverts. La capacité $C_2$ est donc chargée à la tension de référence Vr, toujours dans le même sens.

Comme dans le cas précédent, quand S = $\pm S_D$, le détecteur de niveau commande un monostable ; celui-ci ouvre l'interrupteur double de charge de la capacité $C_2$ et ferme les interrupteurs doubles de décharge. L'interrupteur double de décharge commandé est déterminé en fonction du signe de la tension S de façon à ramener celle-ci vers zéro.

L'impulsion de commande de décharge issue du monostable (ligne 3) est reliée à l'une des sorties $S_1$ ou $S_2$ en fonction de la position de l'inverseur.

Signalons finalement un autre avantage industriel, non évident, de l'intégrateur de précision, selon la présente invention, est de permettre l'emploi d'un circuit monostable à large tolérance, ce qui n'était pas possible dans le montage connu précité, qui exige un circuit monostable à tolérance étroite.

Les domaines d'utilisation d'un intégrateur de ce type sont multiples.

On peut l'utiliser notamment dans l'aéronautique pour numériser la sortie d'un capteur comme par exemple un accéléromètre à rappel asservi (Technique Strap Down).

Le montage selon l'invention consiste dans ce cas à remplacer la grandeur, primitivement électrique, mesurée par l'intégrateur analogique entre A et S, logé dans le rectangle pointillé de la figure 2, par une grandeur physique mise én évidence par un capteur asservi connu en soi, compris entre les bornes A et S de la figure 3.

L'ensemble de la boucle, externe audit rectangle, restant inchangé, cette boucle allant de la borne S à la borne A ou réciproquement comprenant :

— un générateur de tension simple Vr,
— des interrupteurs doubles de charge et de décharge, reliés en parallèles à une capacité $C_2$,
— un circuit monostable (7) commandant directement l'interrupteur de charge ; et un inverseur (3) commandant l'interrupteur de décharge.

La sortie S du composant précité est connectée à un inverseur (3) par l'intermédiaire d'une bascule donnant le signe de tension de sortie ; et d'autre part, à un détecteur de niveau (5) par l'intermédiaire d'un redresseur à double alternance (6), ledit détecteur commandant le circuit monostable (7).

Ce capteur asservi comprent : une bobine (1) de rappel agissant sur un organe mobile (2), schématisé par un pendule dans le cas considéré, se déplaçant dans un champ magnétique (fig. 4).

Le capteur asservi à sorties incrémentales résultant de ce montage est caractérisé en ce que la grandeur à mesurer apparaît sur les bornes de sorties $S_1$, $S_2$, sous forme d'impulsions, qui représentent l'incrément de l'intégrale par rapport au temps de ladite grandeur.

Ce capteur fonctionne comme suit : la force/ou grandeur à mesurer, qui est soit une accélération, soit une giration, agit sur l'organe mobile du capteur ; son détecteur d'écart est relié à un réseau correcteur de phase et de gain, dont la sortie commande l'inverseur 3 à partir du point S.

Le courant $I_2$ de décharge de la capacité $C_2$, peut traverser la bobine 1 de rappel du capteur dans un sens ou dans l'autre (fig. 4).

L'asservissement du capteur connu en soi, comprenant le détecteur d'écart et son réseau correcteur de phase devient par l'intermédiaire du montage de la présente invention, une boucle incrémentale.

Bien entendu, la grandeur physique précitée peut être mise en évidence par un générateur de force électro-mécanique et/ou électro-magnétique.

### Revendications

1. Capteur asservi à sorties incrémentales résultant de l'utilisation d'un intégrateur de précision à sorties incrémentales du type comprenant : un amplificateur opérationnel monté en intégrateur, sommateur analogique qui effectue une somme de courant $I_1$ et $I_2$ à l'entrée de l'intégrateur (point A) ; $I_1$ étant la grandeur à mesurer ; le courant $I_2$ pouvant résulter de la connection d'une résistance $R_2$ à un générateur de tensions symétriques de référence (Vr−) ; (Vr+) par l'intermédiaire de deux interrupteurs (fig. 1) ; la sortie de l'intégrateur analogique (point S) étant connectée d'une part, à un inverseur par l'intermédiaire d'une bascule donnant le signe de la tension de sortie, et d'autre part, à un détecteur de niveau par l'intermédiaire d'un redresseur à double alternance, ledit détecteur commandant un circuit monostable relié à chacun des deux interrupteurs par l'intermédiaire de l'inverseur, ayant pour effet de délivrer à travers la résistance $R_2$ (fig. 1 précisée) des quantités d'électricité calibrées suivant la formule :

$$\Delta Q = \frac{Vr\,(\pm)}{R_2} \times \Delta t \qquad (2)$$

ledit intégrateur étant caractérisé ; en ce que le générateur de tensions symétriques de référence (Vr−) ; (Vr+) est remplacé par un générateur de tension simple (Vr), au moyen duquel une capacité $C_2$ (fig. 2) est chargée, et en ce que le courant $I_2$ est obtenu par la décharge de la capacité $C_2$ (fig. 2) ce qui a pour effet de délivrer des quantités d'électricité calibrées suivant la formule :

$$\Delta Q = C_2\,Vr \qquad (3)$$

intégrateur dans lequel les quantités d'électricité sont stockées dans la capacité $C_2$ au moyen d'un interrupteur double de charge, et les quantités d'électricité sont délivrées au moyen de l'un des deux interrupteurs doubles de décharge, de sorte que le courant $I_2$ équilibre le courant $I_1$ quel que soit le sens de celui-ci.

2. Capteur asservi à sorties incrémentales résultant de l'utilisation d'un intégrateur de précision à sorties incrémentales selon la revendication 1, dans lequel la grandeur à mesurer, primitivement électrique, devient une grandeur physique mise en évidence par un générateur de force, électro-mécanique et/ou électro-magnétique, du fait que l'amplificateur analogique de l'intégrateur de précision à sorties incrémentales (bornes A-S, fig. 2) est remplacé par le générateur de force (fig. 3), dont le courant de rappel est le courant $I_2$ de décharge de la capacité $C_2$ ; le montage précité ayant pour effet de numériser la boucle d'asservissement ; capteur caractérisé en ce que ledit générateur de force comprend une bobine travaillant en rappel, traversée directement par le courant $I_2$ précité de décharge, ce qui a pour effet de minimiser l'écart entre la grandeur à mesurer, convertie en force, et la force de rappel de l'électro-aimant.

3. Capteur asservi selon la revendication 2, caractérisé en ce que la grandeur à mesurer apparaît sur les bornes de sorties $S_1$, $S_2$, sous forme d'impulsions, qui représentent l'incrément de l'intégrale par rapport au temps de ladite grandeur.

### Claims

1. Servoed sensor with digital outputs resulting from the use of a precision integrator with digital outputs of the type comprising : an operational amplifier mounted as integrator, analog summer which sums currents $I_1$, $I_2$ at the integrator input (point A) ; $I_1$ being the order of magnitude to be measured, current $I_2$ the current that results from the connection of a resistor $R_2$ to a symmetrical reference voltage generator (Vr−) ; (Vr+) through two switches (fig. 1) ; the output of the analog integrator (point S) being connected on the one hand to an inverter through a flip-flop giving the sign of the output voltage, and on the other hand to a level detector through a full-wave rectifier, the said detector commanding a monostable circuit connected to each of the two switches through the inverter, the effect of which is to deliver through resistor $R_2$ quantities of electricity calibrated according to the formula :

$$\Delta Q = \frac{Vr(\pm)}{R_2} \times \Delta t \qquad (2)$$

characterized by the fact that the symmetrical reference voltage generator (Vr−) ; (Vr+) is replaced by a single voltage generator (Vr) by means of which a capacitor $C_2$ (fig. 2) is charged, and by the fact that current $I_2$ is obtained by the discharging of capacitor $C_2$ (fig. 2), the effect of which is to deliver quantities of electricity calibrated according to the formula :

$$\Delta Q = C_2\,Vr \qquad (3)$$

integrator in which the quantities of electricity are stored in capacitor $C_2$ by means of a dual charging switch and the quantities of electricity are delivered by means of one of the two dual discharging switches, so that current $I_1$ balances current I, whatever the polarity of the latter.

2. Servoed sensor with digital outputs resulting from the use of a precision integrator with digital outputs according to claim 1, characterized by the fact that the order of magnitude to be measured, originally electrical, becomes a physical order of magnitude evidenced by an electromechanical and/or electromagnetic force generator, owing to the fact that the analog amplifier of the digital-output precision integrator (terminals A-S, fig. 2) is replaced by the force generator (fig. 3), the return current of which is the current $I_2$ from the discharging of capacitor $C_2$ ; the above mentioned set-up having the effect of digitizing the servo-loop ; sensor characterized by the fact that the said force generator comprises a return coil traversed directly by the above-mentioned discharge current $I_2$, the effect of which is to minimize the error between the order of magnitude to be measured, converted into force, and the return force of the electromagnet.

3. Servoed sensor according to claim 2, characterized by the fact that the order of magnitude to be measured appears at output terminals $S_1$ or $S_2$, in the form of pulses, which represent the increment of the integral with respect to time of the said order of magnitude.

**Ansprüche**

1. Rückgekoppelter Sensor mit digitalen Ausgängen resultierend aus der Verwendung eines Präzisionsintegrators und beinhaltend : einen Operationsverstärker aufgebaut als Integrator, einen Analogsummierer welcher die Summe der Ströme $I_1$ und $I_2$ am Eingang des Integrators bilder (Punkt A) $I_1$ stellt die zu messende Grösse dar, $I_2$ ergibt sich aus der Verbindung eines Widerstands $R_2$ mit einer symetrischen Referenzspannungsquelle (VR−, VR+) über 2 Schalter (Bild 1) ; der Ausgang des Analogintegrators (Punkt S) ist einerseits über eine Kippschaltung, welche das Vorzeichen der Ausgangsspannung angibt, mit einem Integrator verbunden und andererseits über einen Vollwellengleichrichter mit einem Pegeldedektor, wobei der besagte Detektor eine monostabile Schaltung ansteuert die mit jedem der beiden Schalter über den Invertierer verbunden ist, mit dem Zweck, den Widerstand $R_1$ geeichte Elektrizitätsmengen zu liefern nach der Formel

$$\Delta Q = \frac{V_r (\pm)}{R_2} \times \Delta t \qquad (2)$$

gekennzeichnet dadurch, dass der symetrische Referenzspannungsgenerator (VR−, VR+) ersetzt wird durch einen einfachen Spannungsgenerator (VR) mit dem ein Kondensator aufgeladen wird und dadurch, dass der Strom $I_2$ gebildet wird durch die Entladung des Kondensators $C_2$ (Bild 2) dessen Zweck es ist, geeichte Elektrizitätsmengen zu liefern entsprechen der Gleichung.

$$\Delta Q = C_2 \, Vr \qquad (3)$$

Integrator, bei dem die Elektrizitätsmengen im Kondensator $C_2$ mittels eines Doppelladungsschalter, und die Elektrizitätsmengen mittels einer der beiden Doppelentladungsschalter so geliefert werden, dass der Strom $I_2$ den Strom $I_1$ bei jeder Richtung desselben ausgleicht.

2. Ruckgekoppelter Sensor mit digitalen Ausgängen sich ergebend aus der Verwendung eines Präzisionsintegrators mit digitalen Ausgängen entsprechend Anspruch 1 gekennzeichnet durch die Tatsache, dass die zu messende Grösse, ursprünglich elektrischer Natur, eine physische Grosse wird, ermittelt durch einen elektromechanischen und oder elektromagnetischen Kraftsensor ; dadurch dass der analoge Verstärker des Prazisionsintegrators (Punkt A-S, Bild 2) ersetzt wird durch den Kraftsensor (Bild 3) dessen Rückstrom der entladestrom $I_2$ des Kondensators $C_2$ ist ; die oben angegebene Anordnung digitalisiert also die Servo-Schleife. Sensor gekennzeichnet dadurch dass der besagte Kraftgenerator eine Rückführrspule enthält, die direkt durch den oven erwähnten Entladestrom $I_2$ durchflossen wird, mit dem Zweck, den Fehler zwischen der Messgrösse, in Kraft umgewandelt, und der Rückführkraft des Electromagnets.

3. Rückgekoppelter Sensor entsprechend Anspruch 2 gekennzeichnet dadurch die Messgrösse erscheint an den Ausgangsklemmen $S_1$ oder $S_2$ in der Form eines Impulses welcher den Zuwachs des Integrals in Bezug auf die Zeit der besagten Messgrösse darstellt.

## FIG.1

## FIG.2

## FIG. 3

FORCE A MESURER

## FIG. 4